# EUROPEAN PATENT APPLICATION

(11) **EP 3 136 607 A1**
(43) Date of publication of application: **01.03.2017**
(21) Application number: 15182490.1
(22) Date of filing: 26.08.2015
(51) Int. Cl.: H03M 7/30

(54) **A METHOD AND A SYSTEM FOR ENCODING AND DECODING OF SUFFIX TREE AND SEARCHING WITHIN ENCODED SUFFIX TREE**

(71) Applicant: Institute of Mathematics and Computer Science, University of Latvia, 1459 Riga (LV)
(72) Inventor: FREIVALDS, Karlis, LV-1459 Riga (LV); VIKSNA, Juris, LV-1459 Riga (LV); GRASMANIS, Mikus, LV-1459 Riga (LV); CELMS, Edgars, LV-1459 Riga (LV)
(74) Representative: Kuzjukevica, Lucija

(57) **Abstract**

The invention relates to a method and system for encoding and decoding of suffix tree, as well as searching within encoded suffix trees. A method for encoding of suffix tree includes: creating a code matrix for each node of suffix tree and encoding all code matrices. Decoding includes: constructing the outgoing edges and outgoing suffix links and their end nodes for root node, and processing nodes in the tree. Searching includes: decoding the root node; decoding the part of the tree which corresponds to given search string; and using additional information in the file to locate the required code matrices in the compressed file. A system further comprises a transcoder unit configured to collect the input data, compress said data as a compressed suffix tree and to store the compressed output stream into the archive. A pattern matcher performs the search within the suffix tree or decoding of suffix tree.

## Description

### Technical field

The present invention relates to a method and system for encoding and decoding of suffix tree, as well as searching within encoded suffix trees.

### Background art

To facilitate searching, various indexing structures can be used, such as suffix trees and suffix arrays. They allow to find a given substring quickly, but increase the size of data. To deal with the amount of data, compression is used. But then, searching is hindered, since only a linear scan through data is the only search possibility that is even more slowed down by the need to decompress data.

There are compressed suffix arrays disclosed in United States patent application publication No. US2009/0063465 and in the paper of Navarro Gonzalo and Veli Makinen (Navarro, Gonzalo, and Veli Mäkinen. "Compressed full-text indexes." ACM Computing Surveys (CSUR) 39.1 (2007): 2) that address the problems by providing a data structure that keeps data in a compressed way, allowing fast search for a given substring. But the implementation is complicated which results in suboptimal performance in practice. Also there is need for random access of compressed data, slowing down implementations in external memory.

In the paper of Sadakane Kunihiko (Sadakane, Kunihiko. "Compressed suffix trees with full functionality." Theory of Computing Systems 41.4 (2007): 589-607) is described an implementation of suffix tree, that occupy significantly less space (O(n) versus traditional O(n log n)) allowing to search quickly but it do not provide space reduction in comparison with the length of the original string.

In the paper of Fischer Johannes et.al. (Fischer, Johannes, Veli Mäkinen, and Gonzalo Navarro. "Faster entropy-bounded compressed suffix trees." Theoretical Computer Science 410.51 (2009): 5354-5364.) there is described an implementation of compressed suffix tree that provides both compression and search. But the implementation is complicated which results in suboptimal performance in practice. Also there is need for random access of compressed data, slowing down implementations in external memory.

### Summary of the Invention

The present invention is a method for encoding and decoding of suffix tree and searching within encoded suffix tree. A method for encoding of suffix tree comprises the steps of: - creating a code matrix for each node of the suffix tree, where each column of the code matrix corresponds to a suffix, each row corresponds to a prefix; and for a node corresponding to a substring S, put 1 in the matrix in position corresponding to prefix *a* and suffix *b*, if a substring *aSb* is present in the input string, put 0 in that position otherwise, and - encoding all code matrices to the compressed output stream.

The code matrices are encoded level by level, starting from the top level and in each level the nodes are ordered lexicographically by the substrings leading to the nodes.

In said method augmentation of the code with additional information is performed allowing to retrieve a particular code matrix without reading the whole compressed stream. The compressed output stream is divided into blocks where each block contains encoded code matrices for some nodes, and block identifiers for edge targets leaving said block.

A compressed suffix tree - a compact representation of a suffix tree allows fast search and takes space that typically is smaller than the data itself - close to that of the state of the art compression programs.

To encode a string of original input data into a compressed stream of bits, the following steps are performed. A suffix tree is created using existing algorithms, for example, algorithms described in the paper of Ukkonen Esko (Ukkonen, Esko. "On-line construction of suffix trees." Algorithmica 14.3 (1995): 249-260.).

A code matrix is created for each node of the suffix tree in the following way. Every node corresponds to some string defined by the symbols on the path of edges from root to the node. Outgoing edges define the possible suffixes of this string. Outgoing suffix links define the possible prefixes. Each column of the code matrix corresponds to a suffix (the first symbol on the edge), row to a prefix. Consider a node corresponding to a substring S, we put 1 in the matrix in position corresponding to prefix *a* and suffix *b*, if and only if substring *aSb* is present in the input string. This property can be easily calculated from the constructed suffix tree.

All code matrices are encoded to the compressed output stream. We encode the code matrices level by level, starting from the top level. Note, when there is a string of more than one symbol as the edge label, the length of an edge is defined as the number of symbols in this string and the length is taken into account to calculate which level the node is in. In each level we order the nodes lexicographically by the substrings leading to the nodes. In the simplest encoding we simply write the bits of the code matrix to the compressed stream.

The following property holds: each row and each column of the matrix contains at least one 1. Therefore we do not encode matrices with either unit width or height - they contain all 1.

In the simplest embodiment we write the bits of matrices into the output stream as they are.
In another embodiment we predict probability of 1 and using entropy coding to encode the bits. Also, when considering the last symbol of a row or column, if all previous was 0, the last one has to be 1 and can be not encoded.

We can use any other compression method to encode the bits of matrices.

In the worst case the length of encoding is O(*n*k*²), where *k* is the alphabet size. We can always use binary alphabet (k = 2). Such encoding immediately is better that original representation of a suffix tree which takes O(*n* log *n*) since each pointer takes space O(log *n*).

For a typical case the code is shorter than the original string due to not encoding unit width or height matrices yielding compression ration comparable or better than other state of the art compression algorithms. Such matrices occur when for a given substring there is only one possibility what can precede it or what can follow it. Such cases are common when the given string contains a lot of repetitions of substrings of a significant length.

A method for decoding of suffix tree encoded by the method described above comprises the steps of: - constructing the outgoing edges and outgoing suffix links and their end nodes for the root node, wherein an edge and a suffix link is constructed for each letter; and - processing nodes in the tree wherein for each node reading of the code matrix for the node from the input stream and constructing of outgoing edges and suffix links for nodes in the next level by creating a suffix link with label 'x' from the child reached through edge with label 'y' from the current node(whose matrix was read) for each '1' in the matrix position corresponding to prefix x and suffix *y*, and creating an edge with label 'y' from the child reached through suffix link with label 'y' from the current node, and creating appropriate end nodes of the new edges and suffix links.

The processing of nodes is performed for nodes level by level in a lexicographic order in each level.

To decode the suffix tree the code matrices are read from the compressed stream and construct a suffix tree level by level (for sake of clarity we will construct a suffix *trie,* in which there is exactly one alphabet symbol on each edge; it is straightforward to modify the algorithm to construct a suffix tree, if needed).

The outgoing edges and outgoing suffix links are constructed for the root node. It is assumed that the alphabet is given, so we construct an edge and a suffix link for each letter and their end nodes(these nodes will be in level 1).

Process all nodes in the tree level by level in a lexicographic order in each level. The first will be the root node. First, read the code matrix for the node from the input stream. Note that we know the dimensions and header rows of the matrices to be read - they correspond to the outgoing edges and suffix links of the node which are already constructed by the time we need to read its code matrix. We do not read matrices with unit width or height - they contain all ones. Second, construct outgoing edges and suffix links for nodes in the next level. For each '1' in the matrix position corresponding to prefix x and suffix *y* we create a suffix link with label 'x' from the child reached through edge with label 'y' from the current node and we create an edge with label 'y' from the child reached through suffix link with label 'y' from the current node. We create the appropriate end nodes of the new edges and suffix links, also.

The process terminates when all nodes in the current level have code matrices of size 1x1, meaning that every extension of their corresponding substrings are uniquely determined. We can recover the original string from the suffix tree, if desired.

A method for searching within a suffix tree encoded by the method described above comprises the steps of: - decoding the root node; - decoding only the part of the tree which corresponds to the given search string; and - using additional information in the file to locate the required code matrices in the compressed file.

If there is a need to traverse an edge whose target is not decoded, the following steps are performed: - finding out the block identifier where the target node is located; - reading said block from file, and - decoding it level by level according to the above described method for decoding.

In most cases we do not need the whole string, but we wish to search for a given substring. In this case we decode only the part of the tree which corresponds to the given search string. To accomplish that, the code has to be augmented with additional information allowing to retrieve a particular code matrix without reading the whole stream.

Additional information for encoder: all nodes are partitioned into blocks where a block contains a connected subtree. Each block contains code matrices of its nodes and information about suffix tree edges going out this block. For each such edge its target block identifier is given. The whole data stream is composed of the blocks and a list of offsets where each block is located in the compressed file. The file size is increased only slightly, since the total number of links between blocks is proportional to the block count as is the number of offsets. Since the block size is typically chosen of several kilobytes, the overhead is negligible.

Substring search algorithm: To search for a substring we decode only those blocks that are traversed during a particular search. We use additional information in the file to locate the required code matrices in the compressed file. The search starts at the root node which is located in the first block and is always decoded. When we need to traverse an edge whose target is not decoded we find out the block identifier where the target node is located, read this block from file, and decode it level by level as described in the decoding algorithm. Note that this decoding may refer to other nodes which are in other blocks and are not yet decoded. Then we recursively invoke the same decoding algorithm for such blocks.

The present invention is also a system for performing the method according to above mentioned steps. The system comprises a CPU (Central Processing Unit), a RAM (Random Access Memory) unit, a compressed archive configured to communicate with the RAM and to store the data, a network interface 1 configured to communicate between a network and the RAM), a network interface 2 configured to communicate between the network and the RAM, and a system bus configured to communicate with and transfer data among the CPU, the compressed archive and the RAM.

The system further comprises a transcoder unit configured to collect the input data from the network interface 1, compress said data as a compressed suffix tree and then to store the compressed output stream into the compressed archive.

The system further comprises a pattern matcher configured to receive a query via the network interface 2, to perform the search within the suffix tree or to decode the suffix tree and to send the results back via the network interface 2. In the simplest embodiment the pattern matcher is configured to receive a substring, or a command to decompress the specified portion of the data.

The transcoder unit is configured to compress the data as compressed suffix tree as described in the above mentioned method. The transcoder unit is configured to create a code matrix for each node of the suffix tree, where each column of the code matrix corresponds to a suffix, each row corresponds to a prefix; and for a node corresponding to a substring S, put 1 in the matrix in position corresponding to prefix *a* and suffix *b*, if a substring *aSb* is present in the input string, put 0 in that position otherwise, and encode all code matrices to the compressed output stream.

The transcoder is configured to encode the code matrices level by level, starting from the top level and in each level the nodes are ordered lexicographically by the substrings leading to the nodes.

The transcoder is configured to perform augmentation of the code with additional information allowing to retrieve a particular code matrix without reading the whole stream.

The transcoder is arranged to divide the compressed output stream into blocks where each block contains encoded code matrices for some nodes, and block identifiers for edge targets leaving said block.

The pattern matcher is configured to perform the search within the suffix tree as described in the above mentioned method. Said pattern matcher is able to perform the search within a suffix tree encoded by decoding the root node; decoding only the part of the tree which corresponds to the given search string; and using additional information in the file to locate the required code matrices in the compressed file.

The pattern matcher, if there is a need to traverse an edge whose target is not decoded, is also configured to perform the following steps: finding out the block identifier where the target node is located; reading said block from file, and decoding it level by level according to the above mentioned method.

The pattern matcher is configured to decode the suffix tree as described in the above mentioned method. The pattern matcher is configured to perform the following steps: constructing the outgoing edges and outgoing suffix links and their end nodes for the root node, wherein an edge and a suffix link is constructed for each letter; and processing nodes in the tree wherein for each node reading of the code matrix for the node from the input stream and constructing of outgoing edges and suffix links for nodes in the next level by creating a suffix link with label 'x' from the child reached through edge with label 'y' from the current node(whose matrix was read) for each '1' in the matrix position corresponding to prefix x and suffix *y*, and creating an edge with label 'y' from the child reached through suffix link with label 'y' from the current node, and creating appropriate end nodes of the new edges and suffix links. The processing of nodes is performed for nodes level by level in a lexicographic order in each level.

The present invention also includes a computer program product comprising software code for performing the operations of a method according above mentioned steps when executed on a digital data processor. It further comprises a computer program product comprising software code for performing the operations of said system when executed on a digital data processor.

### Terms:

A suffix tree is a compressed *trie* containing all the suffixes of the given text as their keys and positions in the text as their values.

The suffix tree for the string S of length *n* is defined as a tree such that: - the tree has exactly *n* leaves numbered from 1 to *n*; *-* except for the root, every internal node has at least two children; - each edge is labelled with a non-empty substring of S; - no two edges starting out of a node can have string-labels beginning with the same character; and - the string obtained by concatenating all the string-labels found on the path from the root to leaf i spells out suffix *S*[*i..n*], for *i* from 1 to *n*.

Since such a tree does not exist for all strings, S is padded with a terminal symbol not seen in the string (here denoted $). This ensures that no suffix is a prefix of another, and that there will be *n* leaf nodes, one for each of the *n* suffixes of S. Since all internal non-root nodes are branching, there can be at most *n -* 1 such nodes, and *n* + (*n -* 1) + 1 = 2n nodes in total (*n* leaves, *n* - 1 internal non-root nodes, 1 root).

Suffix links in a complete suffix tree, all internal non-root nodes have a suffix link to another internal node. If the path from the root to a node spells the string *bA*, where *b* is a single character and *A* is a string (possibly empty), it has a suffix link to the internal node representing *A*. In the present invention a cyclical string is considered. Therefore each substring has at least one prefix and at least one suffix.

The proposed method and system can be used for generalized suffix tree representing a set of strings as well. In this case, each string is made cyclical and the corresponding generalized suffix tree is used. All the described steps work as specified. In this case there is a new search possibility - to find in which string the given substring is located. We accomplish this by using the same search method, but then following the tree edges to decode the continuation of the string. We can decode the whole string or stop at the end marker of the string, which can be complemented with additional information, such as the identifier of the string.

The proposed method and system allows for space-effective storage of an arbitrary stream of textual monitoring data in such compressed form that supports pattern searching without data decompressing, and therefore can be more effective for monitoring devices with limited data storage capacities.

### Brief description of the drawings

The following disclosure will be better understood by a person skilled in the art when read in conjunction with the figures, which show example embodiments. The figures are for the purpose of illustrating example system and method, but it is understood that the various inventions, described herein, are not limited to the arrangements and instrumentality shown in the figures.
Fig. 1 shows a compressed suffix tree of the string *"abacaaabcaa"*.
Fig. 2 shows a system for executing a method for encoding and decoding of suffix tree and searching within encoded suffix tree.

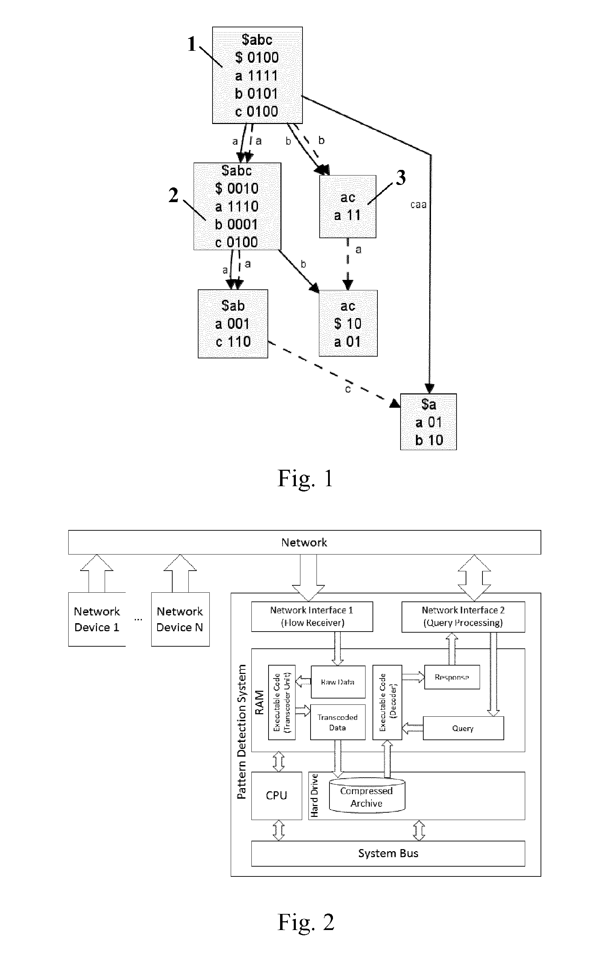

Fig. 1 depicts the suffix tree of the string *"abacaaabcaa"*. Only nodes with code matrices larger than 1x1 are shown. The edge labelled *'caa'* means that it is actually a path of 3 edges with labels '*c*', '*a*' and '*a*'. Symbol '$' is an additional symbol that represents the end of the string. The root node 1 of the tree corresponds to an empty substring. Its code matrix has width and height equal to the alphabet size. The header row displays possible letters following the empty string and the left header column represents letters preceding the empty string(These header rows and columns are only to facilitate reading and are not part of the code ). In the code matrix we can see '1' in as the leftmost symbol of the second row. That means that there exists a substring "*a*$" in the original string. Consider node 2 of the tree corresponding to substring "*a*". The code matrix has '1' according to suffix c and prefix *b* and that means that there exists a substring "*bac*". The code matrix has '0' in position according to suffix c and prefix *a* and that means that there is no substring "*aac*". Node 3 has a matrix of unit height and it contains all ones. According to the simplest embodiment the compressed string is formed of all code matrices, except the matrix of node **3**, yielding a bit string of length 46: "0100111101010100001011100001010000111010010110".

In Fig. 2 is shown a system configured to perform encoding, decoding and search. The system comprises: a CPU (Central Processing Unit); a RAM (Random Access Memory) unit; a compressed archive configured to communicate with the RAM and to store the data; a network interface 1 configured to communicate between a network and the RAM); a network interface 2 configured to communicate between the network and the RAM; and a system bus configured to communicate with and transfer data among the CPU, the compressed archive and the RAM. The system further comprises a transcoder unit configured to collect the input data from the network interface 1, compress said data as a compressed suffix tree and then to store the compressed output stream into the compressed archive. The system further comprises a pattern matcher configured to receive a query (in the simplest embodiment - a substring, or a command to decompress the specified portion of the data) via the network interface 2, to perform the search within the suffix tree or to decode the suffix tree and to send the results back via the network interface 2.

While the inventions have been described with reference to certain embodiments, it will be understood by those skilled in the art that various changes may be made and equivalents may be substituted without departing from the scope of the invention. In addition, many modifications may be made to adapt a particular situation or material to the teachings of the invention without departing from the spirit or scope of the present inventions. Therefore, it is intended that the inventions not be limited to the particular embodiments disclosed herein.

## Claims

1. A method for encoding of suffix tree, wherein the method comprises the steps of:
- creating a code matrix for each node of the suffix tree, where each column of the code matrix corresponds to a suffix, each row corresponds to a prefix; and for a node corresponding to a substring S, put 1 in the matrix in position corresponding to prefix *a* and suffix *b*, if a substring *aSb* is present in the input string, put 0 in that position otherwise,
- encoding all code matrices to the compressed output stream.

2. A method according to claim 1, wherein the code matrices are encoded level by level, starting from the top level and in each level the nodes are ordered lexicographically by the substrings leading to the nodes.

3. A method according to claim 1 or 2, wherein the method includes augmentation of the code with additional information allowing to retrieve a particular code matrix without reading the whole stream.

4. A method according to any one of claims 1 to 3, wherein the compressed output stream is divided into blocks where each block contains
- encoded code matrices for some nodes, and
- block identifiers for edge targets leaving said block.

5. A method for decoding of suffix tree encoded by the method according to any one of claims 1 to 4, wherein the method comprises the steps of:
- constructing the outgoing edges and outgoing suffix links and their end nodes for the root node, wherein an edge and a suffix link is constructed for each letter; and
- processing nodes in the tree wherein for each node reading of the code matrix for the node from the input stream and constructing of outgoing edges and suffix links for nodes in the next level by creating a suffix link with label 'x' from the child reached through edge with label '*y*' from the current node(whose matrix was read) for each '1' in the matrix position corresponding to prefix x and suffix *y*, and creating an edge with label 'y' from the child reached through suffix link with label 'y' from the current node, and creating appropriate end nodes of the new edges and suffix links.

6. A method for decoding according to Claim 5, wherein the processing of nodes is performed for nodes level by level in a lexicographic order in each level.

7. A method for searching within a suffix tree encoded by the method according to any one of the claims 1 to 4, wherein the method comprises the steps of:
- decoding the root node;
- decoding only the part of the tree which corresponds to the given search string;
- using additional information in the file to locate the required code matrices in the compressed file.

8. A method for searching according to Claim 7, wherein, if there is a need to traverse an edge whose target is not decoded, the following steps are performed:
- finding out the block identifier where the target node is located;
- reading said block from file, and
- decoding it level by level according to the method for decoding according to Claims 5 or 6.

9. A system for performing the method according to any previous claim, wherein the system comprises:
- a CPU (Central Processing Unit);
- a RAM (Random Access Memory) unit;
- a compressed archive configured to communicate with the RAM and to store the data;
- a network interface 1 configured to communicate between a network and the RAM);
- a network interface 2 configured to communicate between the network and the RAM;
- a system bus configured to communicate with and transfer data among the CPU, the compressed archive and the RAM;
wherein the system further comprises:
a transcoder unit configured to collect the input data from the network interface 1, compress said data as a compressed suffix tree and then to store the compressed output stream into the compressed archive.
a pattern matcher configured to receive a query via the network interface 2, to perform the search within the suffix tree or to decode the suffix tree and to send the results back via the network interface 2.

10. A system according to Claim 9, wherein the transcoder unit is configured to compress the data as compressed suffix tree as described in the method according to any of Claims 1 to 4.

11. A system according to Claim 9 or 10, wherein the pattern matcher is configured to perform the search within the suffix tree as described in the method according to Claim 7 or 8.

12. A system according to any one of claims 9 to 11, wherein the pattern matcher is configured to decode the suffix tree as described in the method according to Claim 5 or 6.

13. A computer program product comprising software code for performing the operations of a method according to Claims 1 to 8 when executed on a digital data processor.

14. A computer program product comprising software code for performing the operations of a system according to Claims 9 to 12 when executed on a digital data processor.
